# EUROPÄISCHE PATENTSCHRIFT

(11) **EP 1 754 243 B1**
(45) Veröffentlichungstag und Bekanntmachung des Hinweises auf die Patenterteilung: **09.02.2011**
(21) Anmeldenummer: 05754707.7
(22) Anmeldetag: 01.06.2005
(51) Int. Cl.: H01J 37/34

(54) **VORRICHTUNG UND VERFAHREN ZUR ZERSTÄUBUNG MIT EINEM BEWEGBAREN PLANAREN TARGET**
DEVICE AND METHOD FOR SPUTTERING WITH THE AID OF A DISPLACEABLE PLANAR TARGET
DISPOSITIF ET PROCEDE POUR LA PULVERISATION A L'AIDE D'UNE CIBLE PLANE MOBILE

(30) Priorität: 09.06.2004 DE 102004027897
(43) Veröffentlichungstag der Anmeldung: 21.02.2007
(73) Patentinhaber: Leybold Optics GmbH, 63755 Alzenau (DE)
(72) Erfinder: WILLKOMMEN, Udo, 01328 Dresden (DE); HAUSWALD, Ralf, 01817 Prossen (DE); FUKAREK, Wolfgang, 01477 Arnsdorf (DE)
(74) Vertreter: Pohlmann, Bernd Michael
(86) Internationale Anmeldenummer: PCT/EP2005/005898
(87) Internationale Veröffentlichungsnummer: WO 2005/122212

(56) Entgegenhaltungen:
- EP-A- 0 858 095
- US-A- 4 434 037
- US-A1- 2001 045 353
- PATENT ABSTRACTS OF JAPAN Bd. 012, Nr. 446 (C-546), 24. November 1988 (1988-11-24) & JP 63 171880 A (FUJI ELECTRIC CO LTD), 15. Juli 1988 (1988-07-15)

## Beschreibung

Die Erfindung betrifft eine Vorrichtung und ein Verfahren zur Materialzerstäubung mit einem bewegbaren planaren Target jeweils nach den Oberbegriffen der unabhängigen Patentansprüche.

Zur Verbesserung der Zerstäubung von Materialien in einer Vakuumkammer mittels einer Plasmaentladung ist es bekannt, einen Oberflächenbereich eines Targets aus dem zu zerstäubenden Material einem unterstützenden Magnetfeld auszusetzen. Prinzipbedingt hat die Verwendung eines Magnetfeldes eine inhomogene Verteilung der Plasmadichte auf der Targetoberfläche und damit eine inhomogene Materialabtragung von der Targetoberfläche zur Folge. Um eine homogene Beschichtung eines Substrats zu erreichen, ist es üblich, ein derartiges Substrat relativ zu dem als Kathode geschalteten Target zu bewegen. Um eine hohe Ausnutzung eines Targets bei einer magnetfeldunterstützten Zerstäubung zu erreichen, ist es ferner bekannt, ein bewegtes Magnetfeld einzusetzen, um eine Materialabtragung an unterschiedlichen Positionen der Oberfläche zu bewirken. Ferner ist es bekannt, um die Ausnutzung des Targets zu steigern, rotierende, zylindrische oder rotationssymmetrische planare Targets einzusetzen.

Aus der DE 4405747 A1 ist bereits eine kompakte magnetfeldunterstützte Zerstäubungsanordnung bekannt mit einem bewegten rotationssymmetrischen Target und einer stationären Magnetträgeranordnung bekannt. Ein bewegtes Ringtarget ist ferner aus der JP 63-247366 bekannt, bei dem eine uniforme Abtragung der Targetoberfläche erfolgen soll. Ein röhrenförmiges Sputtertarget ist bereits aus der US 4,356,073 bekannt, mit dem eine effektivere und maximale Ausnutzung des Targetmaterials bei gleichzeitig verlängerter Lebensdauer erreicht werden soll. Eine planare Magnetron-Sputtervorrichtung ist aus der JP 59-215485 bekannt, bei der die magnetische Flussdichte durch eine vertikale Bewegung des Targets adjustiert werden kann. Aus der JP 61044 174 ist eine Magnetron-Sputtervorrichtung mit einem als geschlossenes Band ausgebildeten Target bekannt, wobei das Target über rotierende Rollen bewegt wird.

Bei einer bewegten Magneteinrichtung, wie sie im Stand der Technik verwendet wird, oszilliert das Magnetfeld bei langgestreckten Targets typischerweise in bzw. gegen die Bewegungsrichtung des Substrats. Falls zum Beispiel die Geschwindigkeit der Substratbewegung in etwa gleich der Geschwindigkeit des Magnetfeldes ist, variiert die Relativgeschwindigkeit von Substrat und Abtragungszone zyklisch zwischen 0 und 2 v, wobei v die Geschwindigkeit der Substratbewegung ist. Dementsprechend erhält man eine Modulation der Abtragungsrate und damit der Schichtdickengleichmäßigkeit auf dem Substrat.

Aus der DE 102 34858 A1 ist eine Einrichtung zur Erzeugung einer Magnetron-Entladung mit einem als Kathode geschalteten ebenen längsgestreckten Target und einer magnetfelderzeugenden Einrichtung bekannt. Die magnetfelderzeugende Einrichtung ist so ausgeführt, dass sie im Bereich eines Außenpols eine vorgegebene ortsfeste Lage relativ zur äußeren Targetbegrenzung aufweist und im Bereich eines Innenpols mit elektromagnetischen Mitteln derart ausgestattet ist, dass die Lage eines Mittelpols relativ zum Target nach einem vorgebbaren Zeitprogramm geändert werden kann.

Aus der U554434037 ist eine Einrichtung und Methode zur Hochrak Magnekonzurtanbung bekannt. Das als kathode geschactete beweghiche Target wird dabei an einer stationaren Anode vorbeigetährt.

Mit dem bekannten Stand der Technik kann zwar teilweise die Targetausnutzung gesteigert werden, allerdings sind die bekannten Verfahren auf spezielle Targetformen wie Zylinder oder Rotationstargets beschränkt oder erfordern Limitierungen hinsichtlich der Geschwindigkeit oder Form der Bewegung eines zu beschichtenden Substrats aufgrund von Schichtdickenmodulationen durch die Überlagerung der Bewegung des Magnetfeldes mit der des Substrats.

Aufgabe der vorliegenden Erfindung ist die Schaffung einer Zerstäubungsvorrichtung bzw. eines Zerstäubungsverfahrens, mit dem eine hohe Ausnutzung eines planaren Targets unter Vermeidung von Schichtdickenmodulationen erreichbar ist.

Erfindungsgemäß wird die Aufgabe durch die Merkmale der unabhängigen Patentansprüche gelöst. Bevorzugte Weiterbildungen der Erfindung sind den abhängigen Ansprüchen zu entnehmen.

Die erfindungsgemäße Vorrichtung zur Zerstäubung in einer Vakuumkammer mit einer Targeteinrichtung, die zumindest ein in einer Ebene bewegbares planares, als Kathode schaltbares Target, eine stationäre Targetumgebung, eine der Targeteinrichtung zugeordnete Antriebseinrichtung, eine Anodeneinrichtung mit zumindest einer dem Target zugeordneten Anode und eine stationäre Magneteinrichtung zur Erzeugung eines Magnetfeldes zur Unterstützung einer Abtragung von Material von einer Oberfläche des Targets umfasst, weist zumindest ein nicht-rotationssymmetrisches Target auf.

Mit der erfindungsgemäßen Zerstäubungsvorrichtung sind mindestens ebenso hohe Targetausnutzungen erreichbar wie bei Systemen mit bewegten Magnetfeldern. Insbesondere kann ein vorgegebenes Erosionsprofil auf der Targetoberfläche hergestellt werden. Da ein nicht-rotationssymmetrisches Target vorgesehen ist, fallen bei der erfindungsgemäßen Vorrichtung die bisherigen Größenbeschränkungen für zu beschichtende Substrate, wie sie typisch für rotationssymmetrische planare Targets sind, weg. Die erfindungsgemäße Vorrichtung kann vorteilhaft in einem weiten Anwendungsbereich eingesetzt werden, vorzugsweise bei der Herstellung von Displays, Architekturglasbeschichtungen und Bandbeschichtungsanlagen.

Besonders bevorzugt sind als Targetplatte mit einer Rechteck-Form ausgebildete Targets, wie sie vorzugsweise bei Inline-Beschichtungsverfahren eingesetzt werden.

Die stationäre Magneteinrichtung gemäß der Erfindung gewährleistet eine statische Abtragungszone relativ zu einem nicht bewegten Substrat und vermeidet Überlagerungseffekte aufgrund einer bewegten Abtragungszone bei einem bewegten Substrat.

Zumindest eine Anode ist als Splitt-Anode mit zumindest einer stationären Teilanode und zumindest einer mit dem Target gekoppelten bewegten Teilanode ausgebildet ist, da dann besonders einfach und sicher definierte elektrische Verhältnisse zwischen Anode und dem als Kathode geschalteten Target erreichbar sind. Konstruktiv besonders einfach ist es, wenn die stationäre Teilanode an der Targetumgebung angeordnet ist.

Die Antriebseinrichtung kann vollständig oder teilweise in der Vakuumkammer angeordnet sein.

Bei einer Weiterbildung der Erfindung ist die Antriebseinrichtung als Direktantrieb, bevorzugt als Linearmotor ausgebildet, womit eine frei vorgebbare Bewegung des Targets in der Ebene erreicht werden kann.

Bei einer anderen Weiterbildung der Erfindung ist die Antriebseinrichtung als Kurbelantrieb ausgebildet, womit auf kostengünstige Weise eine oszillierende Linearbewegung des Targets erreicht werden kann.

Entsprechende Vorteile wie bei der Vorrichtung zur Zerstäubung bestehen auch bei dem erfindungsgemäßen Verfahren zur Zerstäubung.

Weitere Ausführungsformen und Vorteile der Erfindung sind auch unabhängig von ihrer Zusammenfassung in Patentansprüchen im folgenden ohne Beschränkung der Allgemeinheit anhand einer Beschreibung zusammen mit einer Zeichnung dargestellt.

### Es zeigt

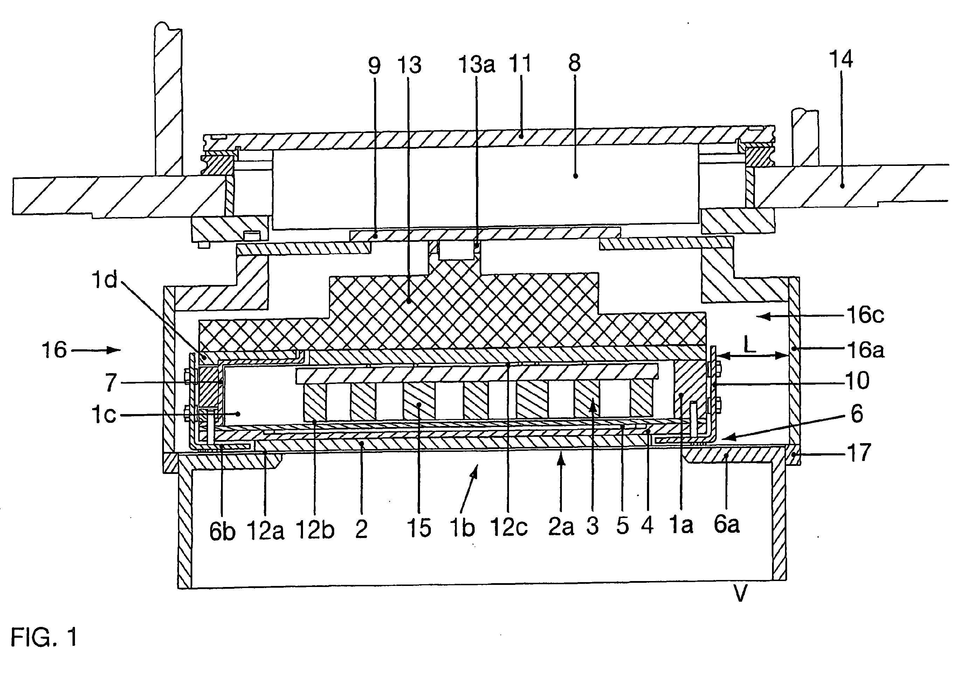

Figur 1 einen Schnitt durch eine erfindungsgemäße Zerstäubungsvorrichtung mit einem Linearmotor.

Figur 1 zeigt in stark schematischer Darstellung eine erfindungsgemäße Vorrichtung 100 zur Beschichtung eines Substrats in einer Vakuumkammer V. Es versteht sich, dass in der Darstellung der Figur 1 zur Vereinfachung an sich bekannte mechanische, elektrische und magnetische Komponenten einer Vorrichtung zur Beschichtung, die sich für den Fachmann als selbstverständlich erschließen, nicht dargestellt sind.

Die erfindungsgemäße Vorrichtung 100 umfasst eine bewegbare Targeteinrichtung, die zumindest ein planares, als Kathode schaltbares Target umfasst. Das Target ist hichtrotationssymmetrisch ausgebildet.

In der Ausführung der Figur 1 ist das Target als Rechteck-Targetplatte 2 mit einer rechteckigen, vorzugsweise langgestreckten Grundfläche ausgebildet, welche auf einer Targetgrundplatte 4 angeordnet ist. Das Target 2 kann aus zwei oder mehr Teiltargets bestehen. Als Material des Targets 2 können alle bei metallischen oder reaktiven Sputter-Prozessen üblichen Sputtermaterialien verwendet werden. Bevorzugte Sputtermaterialien sind Metalle und Metalllegierungen wie Al, Nb, Hf, Ta, Ti, Zr, TiNb sowie Halbleiter wie Si sowie Ito. Bevorzugt ist das Target 2 für eine Beschichtungsbreite von mehr als 0,5 m ausgebildet.

Die Vorrichtung 100 weist ferner eine Magneteinrichtung 3 zur Erzeugung eines Magnetfeldes auf, welches das Target 2 durchdringen kann und mit dem die Abtragung von Material von der Oberfläche 2a des Targets 2 unterstützt wird. Die Magneteinrichtung 3 erzeugt ein die Targetoberfläche 2a durchdringendes Magnetfeld, durch welches ein Erosionsgebiet auf der Targetoberfläche 2a definiert wird, in dem die hauptsächliche Materialabtragung bei der Zerstäubung erfolgt. Die Fläche des Erosionsgebietes auf der Targetoberfläche ist geringer gewählt als die gesamte Targetoberfläche, damit eine Verschiebung der Erosionszone zur Gewährleistung einer möglichst homogenen Abtragung von Material möglich ist. Wie an sich bekannt, ist die stationäre Magneteinrichtung 3 zur Erzeugung von Magnetschläuchen auf zumindest einem Teilbereich der Zerstäubungsoberfläche 2a des Targets 2 ausgebildet. Bei der Ausführungsform gemäß Figur 1 weist die Magneteinrichtung Reihen von Magneten 15 auf, die vorzugsweise aus geeignet konfigurierten Permanentmagnete gebildet sind. Die Magnete 15 sind auf einer Metallplatte 15' angeordnet und weisen zur entgegengesetzten Seite vorzugsweise in einer Ebene liegende Stirnflächen auf. Die Magnetschläuche weisen jeweils eine Längsachse auf, die parallel zueinander orientiert ist. Bevorzugt wird das Target 2 in einer Richtung senkrecht zur Orientierung der Längsachsen bewegt. Es versteht sich jedoch, dass von der Erfindung auch andere Bewegungsmuster des Targets in der Ebene umfasst werden.

Die Targeteinrichtung 1 nutzt als Antriebseinrichtung einen vorzugsweise als Linearmotor ausgebildeten Direktantrieb mit einem Stator 8 und einem Läufer 9. Der Linearmotor ist im Inneren der Vakuumkammer V mittels einer Montageflansch 11 an der Vakuumkammer wand 14 angebracht. In einer alternativen Ausführungsform der Vorrichtung ist der Stator des Linearmotors außerhalb und der Läufer des Linearmotors innerhalb der Vakuumkammer V angeordnet. Auch der Einsatz von anderen Antrieben, die ganz oder teilweise in der Vakuumkammer angeordnet sind ist denkbar. Falls der Antrieb vollständig oder teilweise außerhalb der Vakuumkammer angeordnet ist, kann eine Schiebedurchführung oder ein Metallbalg zur Vakkumdurchführung vorgesehen sein. In einer weiteren Ausführungsform ist ein Metallbalg mit lateraler Bewegung vorgesehen, wobei der Balg vorzugsweise auf der einen Seite an der Isolation 13 und auf der anderen Seite an einer feststehenden Konsole angeschraubt ist.

Der Targeteinrichtung 1 kann alternativ ferner eine Antriebseinrichtung zugeordnet sein, die als Kurbelantrieb ausgebildet ist, mit einem Kurbelarm und einer rotierenden, kugelgelagerten Antriebsrolle, die in einer Kulissenführung bewegbar angeordnet ist. Der Kurbelarm ist über eine Drehdurchführung mit einem Antriebswellenzapfen verbunden, für den ein Drehmoment zur Bewegung des Kurbelarms einleitbar ist.

Die Vorrichtung 100 ist im Inneren der Vakuumkammer V nahe der Vakuumkammerwand 14 angeordnet. Bevorzugt ist die Vorrichtung 100 im Betriebszustand senkrecht gestellt, d.h. in einer gegenüber der Darstellung der Figur 1 um 90 Grad rotierten Position mit einer senkrecht stehenden Targetplatte 2.

Die Vorrichtung 100 umfasst ferner eine Anodeneinrichtung mit zumindest einer dem Target zugeordneten Anode. In der Ausführungsform der Figur 1 ist die Anode als Split-Anode 6 mit einer stationären Teilanode 6a und einer bewegten Teilanode 6b ausgebildet, worauf im folgenden noch genauer eingegangen werden wird.

Mittels In der Figur 1 nicht dargestellter, an sich bekannter Bauteile wird in der Vakuumkammer V im Bereich der Oberfläche des Targets 2 ein Plasma erzeugt, wobei zur Unterstützung der Abtragung von Material von der Targetoberfläche 2a das von der Magneteinrichtung 3 erzeugte Magnetfeld verwendet wird. Bei der erfindungsgemäßen Vorrichtung können sämtliche an sich bekannten Verfahren zur Erzeugung von Plasmen, vorzugsweise Gleichstrom-(DC-), Weahselatrom-(AC-) Plasmen, insbesondere Hochfrequenz-(HF-) Plasmen und Überlagerungen von DC- und AC-Plasmen verwendet werden.

Im Folgenden wird die erfindungsgemäße Vorrichtung 100 detaillierter beschrieben.

Die Targeteinrichtung 1 umfasst ein Targetgehäuse mit einer Vorderseite 1b, einer Rückseite 1d und Schmalseiten 1a, wobei Vorder- und Rückseite im wesentlichen parallel zueinander angeordnet sind. Die Schmalseiten 1a verbinden die Vorderseite und Rückseite und sind ebenfalls im wesentlichen parallel zueinander angeordnet. Vorzugsweise ist das Targetgehäuse ein Rechteckgehäuse. Das Targetgehäuse weist einen Innenbereich 1c auf, in dem die stationäre Magneteinrichtung 3 angeordnet ist. Auf der Rückseite 1d des Rechteckgehäuses ist ein Isolatoraufbau 13 angeordnet, der ein Kopplungselement 13a zur Ankopplung des Targetgehäuses an den Läufer 9 der Antriebseinrichtung aufweist. Das Kopplungselement 13a ist vorzugsweise als Trägerstruktur ausgebildet. Der Isolatoraufbau 13, 13a dient der Verhinderung bzw. Unterdrückung von parasitären Plasmen im Bereich der Rückseite 1d des Targetgehäuses.

Das Targetgehäuse ist bewegbar in einer stationären Targetumgebung 16 untergebracht. Die Targetumgebung 16 ist vorzugsweise derart ausgebildet, dass die Außenform des Targetgehäuses der Innenform der Targetumgebung 16 angepasst ist. In der in der Figur 1 dargestellten Ausführungsform der Erfindung weist die Targetumgebung 16 einen in der Form des Rechteckgehäuses angepassten Rechteck-Innenbereich 16c auf. Einer Schmalseite 1a des Targetgehäuses 1 ist eine Schmalseite 16a der Targetumgebung 16 zugeordnet. Das Targetgehäuse kann innerhalb des Innenbereichs 16c der Targetumgebung 16 eine Bewegung mit einem Hub L ausführen. Die Magneteinrichtung 3 weist eine Außenform auf, die der innenform des Targetgehäuses angepasst ist. Das Targetgehäuse kann in Hinblick auf die Magneteinrichtung 3 eine Bewegung mit einem Hub ausführen, der vergleichbar dem Hub L der Bewegung des Targetgehäuses innerhalb des Innenbereichs 16c der Targetumgebung 16 entspricht. Halte- und Führungsmittel erlauben die Durchführung einer vorgebbaren Bewegung des Targetgehäuses und damit des Targets 2 in einer Ebene im Bereich der Targetumgebung 16. Als Halte- und Führungsmittel sind wie an sich bekannt Rollenlager, Schienen oder dergleichen vorgesehen.

Das Targetgehäuse, die Targetumgebung 16, die Anodeneinrichtung 6 und die Magneteinrichtung 3 weisen korrespondierende und relativ zueinander bewegte Komponenten auf, die auf unterschiedlichem Potential liegen können. Vorzugsweise liegen das Target 2 sowie weitere Komponenten der Targeteinrichtung 1 wie die Targetgrundplatte 4 auf einem Potential gegenüber Masse zwischen minus 40 und minus 400 V. Zur präzisen Festlegung des Potentials der Targetplatte ist eine Versorgungsleitung 7 im Inneren des Targetgehäuses vorgesehen. Die Magneteinrichtung 3 liegt vorzugsweise auf dem gleichen Potential wie die erwähnten Komponenten der Targeteinrichtung 1. Die Anodeneinrichtung 6a liegt vorzugsweise auf Masse oder einem positiven Potential. Besonders bevorzugt ist es, wenn die Anodeneinrichtung auf einem gegenüber Masse positivem Potential liegt. Die Kathodenumgebung 16 liegt vorzugsweise auf einem positiven Potential.

Erfindungsgemäß kann das Target 2 in einer Ebene im Bereich der Targetumgebung 16 eine Bewegung ausführen, bei der der Abstand zwischen korrespondierenden Teilen des Targetgehäuses und der Targetumgebung 16 größer als die für den faradayischen Dunkelraum charakteristische Länge ist. Bei einem solchen Abstand kann in dem Raum zwischen den betreffenden Oberflächen ein parasitäres Plasma zünden. Die Entstehung von derartigen parasitären Plasmen wird durch das Vorhandensein von magnetischen Feldern, die von der Magneteinrichtung 3 auch außerhalb des Bereichs der Kathodenoberfläche erzeugt werden, begünstigt. Zur Vermeidung oder Unterdrückung von derartigen parasitären Plasmen ist an zumindest einer Außenseite des Targetgehäuses eine Dunkelraumabschirmung angeordnet. Derartige Dunkelraumabschirmungen sind an sich bekannt und durch einen Spalt von einer als Kathode geschalteten Komponente getrennt, der derart dimensioniert ist, dass zwischen der besagten Komponente und der Abschirmung kein Plasma zünden kann. Insbesondere ist eine Dunkelraumabschirmung an zumindest einem Teilbereich der Oberfläche der Schmalseite und/oder einem Teilbereich der Oberfläche der Vorderseite des Rechteckgehäuses vorgesehen.

Die Dunkelraumabschirmung kann auf einem flaotendem Potential, auf Massepotential oder auf einem positiven Potential liegen. In einer Weiterbildung der Erfindung ist zumindest eine mit der Kathode gekoppelte Dunkelaumabschirmung auch als bewegbare Anode ausgebildet und einer stationären Teilanode elektrisch verbunden.

Es versteht sich, dass die Dunkelraumabschirmung gemäss der Geometrie von Targetgehäuse und Targetumgebung 16 ausgebildet ist. Eine Dunkelraumabschirmung 10 ist an der Schmalseite 1a angeordnet. Diese Dunkelraumabschirmung erstreckt sich auch auf einen Teilbereich der Oberflächen der Vorderseite 1b des Targetgehäuses. Bevorzugt ist eine sämtliche Schmalseiten des Targetgehäuses bedeckende Dunkelraumabschirmung. Die an der Vorderseite 1b des Targetgehäuses angeordnete Dunkelraumabschirmung 10 kann die Targetplatte 2 vollständig oder teilweise umlaufend ausgebildet sein.

Bei der in Figur 1 dargestellten Ausführungsform der Erfindung ist die Dunkelraumabschirmung 10 gleichzeitig Teilanode 6b der Splittanode 6, wobei eine nicht dargestellte vorzugsweise flexible elektrische Verbindungsleitung zwischen stationärer Teilanode 6a und bewegter Teilanode 6b vorgesehen ist. In einer weiteren Ausführungsform ist keine derartige Verbindungsleitung vorgesehen. Die Anodeneinrichtung 6 bzw. die Teilanoden 6a, 6b überlappen mit der Kathodenoberfläche 2a auch in den Extrempositionen der Bewegung des Targets, insbesondere zur Gewährleistung von definierten elektrischen Verhältnissen zwischen Anode und Kathode beim Betrieb der erfindungsgemäßen Vorrichtung.

Die stationäre Teilanode 6a ragt in den Bereich der Vorderseite 1 b des Targetgehäuses zungenartig hinein. Dabei wird ein Überlappungsbereich zwischen dem Targetgehäuse im Bereich der Vorderseite 1b und der stationären Teilanode 6a gebildet. Es kann auch eine Überlappung zwischen der Targetoberfläche 2a und der stationären Teilanode 6a auftreten. Zur Vermeidung von nicht erwünschten Plasmen ist der dabei zwischen der Targetoberfläche 2a und der stationären Teilanode 6a auftretende Schlitz 12a genügend klein dimensioniert.

### BEZUGSZEICHENLISTE

- 1: Targeteinrichtung
- 1a: Seitenwandung
- 1b: Uorderseite
- 1c: Innenbereich
- 1d: Rückseite
- 2: Target
- 2a: Oberfläche des Targets
- 3: Magneteinrichtung
- 4: Targetgrundplatte
- 5: Kühlkanal
- 6a: stationäre Teilanode
- 6b: bewegbare Anode
- 6: Anodeneinrichtung
- 7: Kathodenversorgung
- 8: Stator
- 9: Läufer
- 10: DunKelraumabschirmelement
- 11: Montageflansch
- 12a: Spalt
- 12b: Spalt
- 12c: Spalt
- 12d: Spalt
- 12e: Spalt
- 13: Isolatorelement
- 14: Vakuumkammerwand
- 15: Magnetlinie
- 16: Targetumgebung
- 16a: Seitenwand
- 16b: obere Wandung
- 17: lsolatorelement
- 18: Montageflansch
- L: Hub
- V: Vakuumkammer

## Patentansprüche

1. Vorrichtung zur Material - Zerstäubung in einer Vakuumkammer mit einer bewegbaren Targeteinrichtung (1), die zumindest ein in einer Ebene bewegbares planares, als Kathode schaltbares Target (2) umfasst mit
einer stationären Targetumgebung (16)
einer der Targeteinrichtung zugeordneten Antriebseinrichtung (8,9) einer Anodeneinrichtung (6) mit zumindest einer dem Target zugeordneten Anode und einer stationären Magneteinrichtung (3) zur Erzeugung eines Magnetfeldes zur Unterstützung einer Abtragung von Material von einer Zerstäubungsoberfläch (2a) des Targets, wobei zumindest ein nicht-rotationssymmetrisches, vorzugsweise als Rechteck-Targetplatte ausgebildetes Target (2), vorgesehen ist, welches mittels der Targeteinrichtung In einer Ebene bewegbar ist, **dadurch gekennzeichnet, dass** eine Splitt -Anode (6) mit zumindest einer stationären Teilanode (6a) und zumindest einer mit der Targeteinrichtung gekoppelten bewegbaren Anode (6b) vorgesehen ist.

2. Vorrichtung nach Anspruch 1, weiter **dadurch gekennzeichnet, dass** die Targeteinrichtung ein Targetgehäuse mit einem Innenbereich (1c) umfasst, die stationäre Magneteinrichtung in dem Innenbereich des Targetgehäuses angeordnet ist und dass die stationäre Targetumgebung einen Innenbereich umfasst, in dem das Targetgehäuse angeordnet ist.

3. Vorrichtung nach Anspruch 2, **dadurch gekennzeichnet, dass** das Targetgehäuse als Rechteckgehäuse mit einer Vorderseite (1b), einer Rückseite (1d) und Schmalseiten (1a) ausgebildet ist, wobei das Target (2) im Bereich der Vorderseite angeordnet ist.

4. Vorrichtung nach Anspruch 2 oder 3, weiter **dadurch gekennzeichnet, dass** an zumindest einer Außenseite des Targetgehäuses eine Dunkelraumabschirmung (10) zur Unterdrückung von parasitären Plasmen angeordnet ist.

5. Vorrichtung nach Anspruch 4, weiter **dadurch gekennzeichnet, dass** die Dunkelraumabschirmung (10) in zumindest einem Teilbereich der Oberfläche der Schmalseite (1a) und/oder einem Teilbereich der Oberflächen der Vorderseite (1b) des Rechteckgehäuses angeordnet ist.

6. Vorrichtung nach zumindest einem der Ansprüche 2 bis 5, weiter **dadurch gekennzeichnet, dass** auf der Rückseite des Rechteckgehäuses ein Isofatoraufbau (13) angeordnet ist, der ein Kopplungselement (13a) zur Ankopplung des Targetgehäuses an die Antriebseinrichtung beinhaltet

7. Vorrichtung nach zumindest einem der vorhergehenden Ansprüche, weiter **dadurch gekennzeichnet, dass** die stationäre Magneteinrichtung (3) zur Erzeugung von Magnetschläuchen auf zumindest einem Teilbereich der Zerstäubungsoberfläche (2a) des Targets (2) ausgebildet ist.

8. Vorrichtung nach einem der vorhergehenden Ansprüche, weiter **dadurch gekennzeichnet, dass** die Antriebseinrichtung als Direktantrieb, vorzugsweise als Linearmotor ausgebildet ist.

9. Vorrichtung nach Anspruch 8, weiter **dadurch gekennzeichnet, dass** der Linearmotor einen innerhalb der Vakuumkammer angeordneten Stator (8) aufweist.

10. Vorrichtung nach Anspruch 9, weiter **dadurch gekennzeichnet, dass** der Linearmotor einen außerhalb der Vakuumkammer angeordneten Stator (8) aufweist.

11. Vorrichtung nach zumindest einem der vorhergehenden Ansprüche, weiter **dadurch gekennzeichnet, dass** die Antriebseinrichtung als Kurbelantrieb, vorzugsweise mit einem Kurbelarm, einer Antriebsrolle und einer Kulissenführung ausgebildet ist.

12. Vorrichtung nach einem der vorhergehenden Ansprüche, weiter **dadurch gekennzeichnet, dass** die Magneteinrichtung als Sputter-Magnetron ausgebildet ist.

13. Vorrichtung nach zumindest einem der vorhergehenden Ansprüche, weiter **dadurch gekennzeichnet, dass** ein metallisches Target vorgesehen ist.

14. Vorrichtung nach einem der Ansprüche 1 bis 14, weiter **dadurch gekennzeichnet, dass** ein Oxid-Target vorgesehen ist.

15. Vorrichtung nach einem der vorhergehenden Ansprüche, weiter **dadurch gekennzeichnet, dass** die Dunkelraumabschirmung auf Masse oder floatendem Potential liegt

16. Verfahren zur Material - Zerstäubung in einer Vakuumkammer mit einer bewegbaren Targeteinrichtung weiter, (1) die zumindest ein in einer Ebene bewegbares planares, als Kathode schaltbares Target (2) umfasst mit
einer stationären Targetumgebung (16)
einer der Targeteinrichtung zugeordneten Antriebseinrichtung (8,9) einer Anodeneinrichtung (6) mit zumindest einer dem Target zugeordneten Anode und
einer stationären Magneteinrichtung (3) zur Erzeugung eines Magnetfeldes zur Unterstützung einer Abtragung von Material von einer Zerstäubungsobertläche (2a) des Targets (2), wobei zumindest ein nicht-rotationssymmetrisches, vorzugsweise als Rechteck-Targetplatte ausgebildetes Target (2), vorgesehen ist, welches mittels der Targeteinrichtung in einer Ebene bewegt wird, **dadurch gekennzeichnet, dass** eine Splitt-Anode (6) mit zumindest einer stationären Teilanode (6a) und zumindest einer mit der Targeteinrichtung gekoppelten bewegbaren Anode (6b) verwendet wird.

## Claims

1. Apparatus for sputtering material in a vacuum chamber with a movable target device (1), which comprises at least one planar target (2), which is movable in a plane and can be connected as a cathode, with
a stationary target environment (16),
a drive device (8, 9), assigned to the target device,
an anode device (6), with at least one anode assigned to the target, and
a stationary magnetic device (3), for producing a magnetic field to assist removal of material from a sputtering surface (2a) of the target, at least one non-rotationally symmetrical target (2) being provided, which is preferably formed as a rectangular target plate and can be moved in a plane by means of the target device, **characterized in that** a split anode (6) is provided, with at least one stationary part-anode (6a) and at least one movable anode (6b), coupled to the target device.

2. Apparatus according to Claim 1, further **characterized in that** the target device comprises a target housing with an inner region (1c), the stationary magnetic device is arranged in the inner region of the target housing and **in that** the stationary target environment comprises an inner region in which the target housing is arranged.

3. Apparatus according to Claim 2, **characterized in that** the target housing is formed as a rectangular housing with a front side (1b), a rear side (ld) and narrow sides (1a), the target (2) being arranged in the region of the front side.

4. Apparatus according to Claim 2 or 3, further **characterized in that** a darkroom shielding (10) is arranged on at least one outer side of the target housing to suppress parasitic plasmas.

5. Apparatus according to Claim 4, further **characterized in that** the darkroom shielding (10) is arranged in at least a partial region of the surface of the narrow side (1a) and/or a partial region of the surface of the front side (1b) of the rectangular housing.

6. Apparatus according to at least one of Claims 2 to 5, further **characterized in that** an insulator structure (13), which comprises a coupling element (13a) for coupling the target housing to the drive device, is arranged on the rear side of the rectangular housing.

7. Apparatus according to at least one of the preceding claims, further **characterized in that** the stationary magnetic device (3) is formed for producing magnetic plumes on at least a partial region of the sputtering surface (2a) of the target (2).

8. Apparatus according to one of the preceding claims, further **characterized in that** the drive device is formed as a direct drive, preferably as a linear motor.

9. Apparatus according to Claim 8, further **characterized in that** the linear motor has a stator (8) arranged inside the vacuum chamber.

10. Apparatus according to Claim 9, further **characterized in that** the linear motor has a stator (8) arranged outside the vacuum chamber.

11. Apparatus according to at least one of the preceding claims, further **characterized in that** the drive device is formed as a crank drive, preferably with a crank arm, a drive roller and a connecting link guide.

12. Apparatus according to one of the preceding claims, further **characterized in that** the magnetic device is formed as a sputtering magnetron.

13. Apparatus according to at least one of the preceding claims, further **characterized in that** a metallic target is provided.

14. Apparatus according to one of Claims 1 to 14, further **characterized in that** an oxide target is provided.

15. Apparatus according to one of the preceding claims, further **characterized in that** the darkroom shielding is at earth or floating potential.

16. Method for sputtering material in a vacuum chamber with a movable target device (1), which comprises at least one planar target (2), which is movable in a plane and can be connected as a cathode, with
a stationary target environment (16),
a drive device (8, 9), assigned to the target device,
an anode device (6), with at least one anode assigned to the target, and
a stationary magnetic device (3), for producing a magnetic field to assist removal of material from a sputtering surface (2a) of the target (2), at least one non-rotationally symmetrical target (2) being provided, which is preferably formed as a rectangular target plate and is moved in a plane by means of the target device, **characterized in that** a split anode (6) is used, with at least one stationary part-anode (6a) and at least one movable anode (6b), coupled to the target device.

## Revendications

1. Dispositif de pulvérisation de matériau dans une chambre sous vide qui présente un dispositif mobile de cible (1) qui comprend au moins une cible (2) plane mobile dans un plan, commutable en cathode et qui comprend :
un environnement stationnaire (16) de cible,
un dispositif d'entraînement (8, 9) associé au dispositif de cible,
un dispositif d'anode (6) qui présente au moins une anode associée à la cible et
un dispositif magnétique stationnaire (3) qui forme un champ magnétique qui soutient l'extraction de matière d'une surface de pulvérisation (2a) de la cible,
au moins une cible (2) ne présentant pas de symétrie de rotation et de préférence configurée comme plaque rectangulaire de cible étant prévue et pouvant être déplacée dans un plan au moyen d'un dispositif de cible,
**caractérisé en ce que**
une anode divisée (6) qui présente au moins une partie stationnaire (6a) d'anode et au moins une partie mobile (6b) d'anode couplée au dispositif de cible est prévue.

2. Dispositif selon la revendication 1, **caractérisé en outre en ce que** le dispositif de cible comprend un boîtier de cible qui présente une partie intérieure (lc), **en ce que** le dispositif magnétique stationnaire est disposé dans la partie intérieure du boîtier de cible et **en ce que** l'environnement stationnaire de cible présente une partie intérieure dans laquelle est disposé le boîtier de cible.

3. Dispositif selon la revendication 2, **caractérisé en ce que** le boîtier de cible est configuré comme boîtier rectangulaire présentant un côté avant (1b), un côté arrière (1d) et des côtés étroits (1a), la cible (2) étant disposée au niveau de la partie avant.

4. Dispositif selon les revendication 2 ou 3, **caractérisé en outre en ce qu'**un blindage d'espace sombre (10) qui inhibe les plasmas parasites est disposé sur au moins un côté extérieur du boîtier de cible.

5. Dispositif selon la revendications 4, **caractérisé en outre en ce que** le blindage (10) d'espace sombre est disposé dans au moins une partie de la surface du côté étroit (1a) et/ou dans une partie de la surface du côté avant (1b) du boîtier rectangulaire.

6. Dispositif selon au moins l'une des revendications 2 à 5, **caractérisé en outre en ce qu'**une structure isolante (13) qui contient un élément d'accouplement (13a) qui accouple le boîtier de cible au dispositif d'entraînement est disposée sur le côté arrière du boîtier rectangulaire.

7. Dispositif selon au moins l'une des revendications précédentes, **caractérisé en outre en ce que** le dispositif magnétique stationnaire (3) est configuré pour former des manchons magnétiques sur au moins une partie de la surface de pulvérisation (2a) de la cible (2).

8. Dispositif selon l'une des revendications précédentes, **caractérisé en outre en ce que** le dispositif d'entraînement est configuré comme entraînement direct et de préférence comme moteur linéaire.

9. Dispositif selon la revendication 8, **caractérisé en outre en ce que** le stator (8) du moteur linéaire est disposé à l'intérieur de la chambre sous vide.

10. Dispositif selon la revendication 9, **caractérisé en outre en ce que** le stator (8) du moteur linéaire est disposé à l'extérieur de la chambre sous vide.

11. Dispositif selon au moins l'une des revendications précédentes, **caractérisé en outre en ce que** le dispositif d'entraînement est configuré comme entraînement à manivelle, de préférence doté d'un bras de manivelle, d'un galet d'entraînement et d'un coulisseau de guidage.

12. Dispositif selon l'une des revendications précédentes, **caractérise en outre en ce que** le dispositif magnétique est configuré comme magnétron de pulvérisation.

13. Dispositif selon au moins l'une des revendications précédentes, **caractérisé en outre en ce qu'**il présente une cible métallique.

14. Dispositif selon l'une des revendications 1 à 14, **caractérisé en outre en ce qu'**il présente une cible d'oxyde.

15. Dispositif selon l'une des revendications précédentes, **caractérisé en outre en ce que** le blindage d'espace sombre est placé au potentiel de masse ou à un potentiel flottant.

16. Procédé de pulvérisation de matière dans une chambre sous vide qui présente un dispositif mobile (1) de cible qui comprend au moins une cible (2) plane apte à être déplacée dans un plan, commutable en cathode et qui comprend :
un environnement stationnaire (16) de cible,
un dispositif d'entraînement (8, 9) associé au dispositif de cible,
un dispositif d'anode (6) qui présente au moins une anode associée à la cible et
un dispositif magnétique stationnaire (3) qui forme une champ magnétique qui soutient l'extraction de matière d'une surface de pulvérisation (2a) de la cible (2),
au moins une cible (2) ne présentant pas de symétrie de rotation et de préférence configurée comme plaque rectangulaire de cible étant prévue et pouvant être déplacée dans un plan au moyen d'un dispositif de cible,
**caractérisé en ce que**
il utilise une anode divisée (6) qui présente au moins une partie stationnaire (6a) d'anode et au moins une partie mobile (6b) d'anode couplée au dispositif de cible.
